# EUROPEAN PATENT APPLICATION

(11) **EP 0 893 698 A1**
(43) Date of publication of application: **27.01.1999**
(21) Application number: 97305549.4
(22) Date of filing: 24.07.1997
(51) Int. Cl.: G01R 31/28, G06F 11/26

(54) **Programmable simulator**

(71) Applicant: PI Technology Limited, Milton, Cambridge, CB4 6AB (GB)
(72) Inventor: Tebby, Graham Paul, Foxton, Cambridgeshire (GB)
(74) Representative: Brunner, Michael John

(57) **Abstract**

A programmable simulator (1) for use in the testing of automobile electronic control modules (ECMs) (10), has a chassis (2) on which is mounted an input/output section (4) having pluralfirst (41) and second (42) multi-terminal electrical connectors for coupling to input/output interface cards (43), the second connectors (42) being connected to corresponding input/output ports (11-17,19). Also supported on the chassis is an IBM-standard personal computer (PC), the PC having a standard data/address bus and plural third multi-terminal electrical connectors (33) for the coupling of standard PC interface cards (34) within the PC. A bus extension (5) extends the standard data/address bus of the PC to each of the first connectors (41) of the input/output section (4), so that an input/output interface card (43) engaged with the corresponding first and second connectors (41,42) may be used to provide output signals to or to receive input signals from the ECM (10) to enable the simulation of appropriate inputs/outputs to/from the ECM (10) attached to the simulator via the input/output ports, under the control of software running on the PC (3).

## Description

The present invention relates to programmable simulators and, more particularly, to a real-time simulator which enables rigorous and controlled testing of automotive electronic control modules (ECMs). The simulator can be used to simulate a variety of components, including engines, transmissions and gearboxes.

Programmable simulators of this type have conventionally comprised dedicated systems, ie equipment designed specifically and solely for the specific task, such systems comprising proprietary designs using non-standard architecture. A drawback of such systems is their inability to interface easily with standard software and hardware. This problem, combined with high cost, due to the lengthy development and specialised manufacture, are factors in limiting the increased use of such systems.

An aim of the present invention is therefore to provide a general purpose simulation tool utilising a standard architecture as far as possible without compromising other aims. As a tool, the simulator is in the same category as an oscilloscope. The end user must not be concerned with how the tool works neither must problems found by the user be the fault of the tool. It must therefore be easy to use and very reliable. It must also be able to withstand a reasonable amount of abuse since it is used within a development environment where things are tried for the first time and mistakes are made. The tool must also be neatly packaged as bench space is always at a premium. Furthermore as the required simulation will vary both between users and between projects for any one user and thus the simulation will vary in size, complexity and speed it can be predicted that all three of these requirements will generally increase. The simulator must therefore be very flexible, easily configured and expanded. A further requirement is for the simulator to be cost efficient. This inevitably involves trade-offs against the other design goals.

These requirements lead to a consideration of the use of a standard "IBM-compatible" personal computer (PC). However, on further consideration it will be appreciated that difficulties exist with such an approach. These stem from, for example, the recognition that, to provide a flexible system, any changes must be quick and easy to make, since different projects may require use of the simulator within a short period of time. The use of a standard PC therefore, with its limited capability for expansion and the difficulty in altering its configuration quickly, has disadvantages. One serious disadvantage is the standard input/output (I/O) slot connector used in PCs. These are not designed for repeated insertion/withdrawal cycles. This does not matter in a standard PC, but should a card need changing (or component on it need altering) for two different projects, the maximum number of insertion and withdrawal cycles (typically only tens of cycles, dependent upon the plating on the PCB) can easily be exceeded. Additionally, industry standard (ISA) I/O interface cards are designed for industrial process control and as such do not have the necessary signal conditioning, drive capability and protection for the automotive ECM environment. Furthermore, available ISA I/O cards sometimes lack the performance required.

However, moving completely away from standard cards would mean that the simulator would be too specialized as mentioned above, with the user locked in to one manufacturer.

According to the present invention therefore, there is provided a programmable simulator for use in the testing of automobile electronic control modules (ECMs), the simulator comprising
a chassis;
an input/output section having a plurality of first and second multi-terminal electrical connectors for coupling to input/output interface cards, the second connectors being connected to corresponding input/output ports supported on the chassis;
an IBM-standard personal computer (PC) mounted on the chassis, the PC having a standard data/address bus therein and a plurality of third multi-terminal electrical connectors for the coupling of standard PC interface cards within the PC; and
a bus extension extending the standard data/address bus to each of the first connectors of the input/output section, thereby extending the bus to the input output section,
   whereby an input/output interface card engaged with the corresponding first and second connectors may be used to provide output signals to or to receive input signals from, corresponding ones of the input/output ports to enable the simulation of appropriate inputs/outputs to/from an ECM attached to the simulator via the input/output ports, under the control of software running on the PC.

Preferably, the first and second connectors of the input/output section are arranged in parallel rows whereby an associated input/output card can be connected to the respective first and second connectors adjacent to one edge.

Advantageously, the connection of the second connectors with the input/output ports is achieved by the use of individual multi-conductor cables.

Preferably, the PC standard bus is an ISA, EISA or PCI bus and the bus extension comprises a ribbon cable connected to the bus and to all of the first connectors.

The programmable simulator of the invention makes the testing of ECMs less complex and more rigorous than connecting the ECM to a conventional simulator. The testing process can be fast and repeatable.

In order to overcome the problems with ISA I/O cards and the difficulty of providing a separate rack of signal conditioning cards (connections to such a rack are problematic in a standard PC since there is no standard for either the pin-out or the connector for the I/O of these cards and the height of the rack is increased undesirably, which makes changing cards in a modular way a rather inelegant operation) the input/output section of the simulator according to the invention provides for connection of I/O interface cards to an extension of the standard bus, whether this be ISA, EISA or PCI.

A potentially severe bottle-neck is the ISA bus itself - it is much slower than the bus the CPU uses - so data transfer must therefore be made very efficient, avoiding 8 bit transfers if possible. For PWM input and outputs, 16 bit counters are not usually sufficient due to the large dynamic range of engine speeds (nearly four orders of magnitude). Therefore, the simulator of the invention is preferably hybrid; it is preferably based on a standard ISA/PCI backplane with standard processor and network cards etc., plus several spare slots. The ISA bus is also extended on to (preferably) a VME rack system within the I/O section. The same signals are brought across, but on to standard VME format cards. A range of I/O cards which have the required I/O and the signal conditioning can thus be offered to users. These can contain an efficient bus interface together with the required performance and signal conditioning on a single board which is more reliable by virtue of the well proven VME racking system, however, the extended bus remains ISA/EISA/PCI - it is only the rack/card format that is VME).

The basic architecture of the simulator is thus that of a standard IBM-compatible PC with an extended ISA/EISA/PCI bus. This allows the use of industry standard cards and the ability to advance with the quickly improving technology, such as faster processors, more memory, and better storage systems. It gives a familiar development environment for software in which many tools are cheaply available, and it allows the user to install proprietary ISA/EISA/PCI cards if required, and means that the user is not 'locked in' to any one manufacturer.

Advantages provided by the invention include:
- reduced testing time compared to using a conventional static simulator,
- excellent test coverage, enabling the development of high quality ECMs;
- automated mode of operation reduces the level of operator dependence and facilitates regression testing;
- applicability to a range of ECMs means that the same tool can be used across an organization in ECM development projects;
- open architecture means that the tool can be expanded and enhanced to meet evolving needs;
- a compact bench-top tool, which provides all the required functionality without needing large amounts of space.

One example of a programmable simulator constructed in accordance with the present invention will now be described with reference to the accompanying drawings, in which:
Figure 1 illustrates the hardware architecture of the simulator;
Figure 2 is a diagrammatic illustration of the front of the simulator;
Figure 3 is a diagrammatic illustration of the rear of the simulator, from which a rear cover plate has been removed; and
Figure 4 is a diagrammatic illustration of the top of the simulator, also with its cover removed.

The programmable simulator 1 for connection to an automotive ECM 10, comprises a frame 2 in which are disposed a standard IBM-compatible PC 3 (mainly at the top and front), an input/output section 4 including (in this example) a VME type rack (at the back) and an input/output plane at the front 6 of the simulator, and a PC bus extension cable 5 extending between the PC and the input/output section 4. The frame has fixed front, side and rear panels 6,7,8 and a removable top cover (not shown).

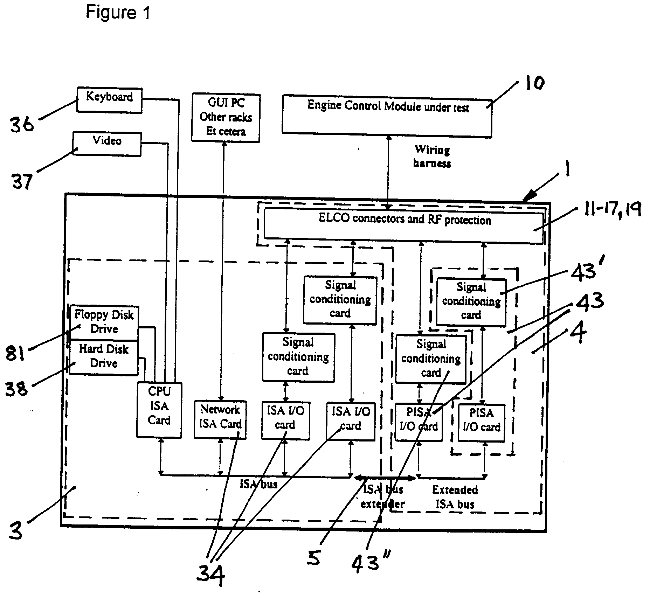

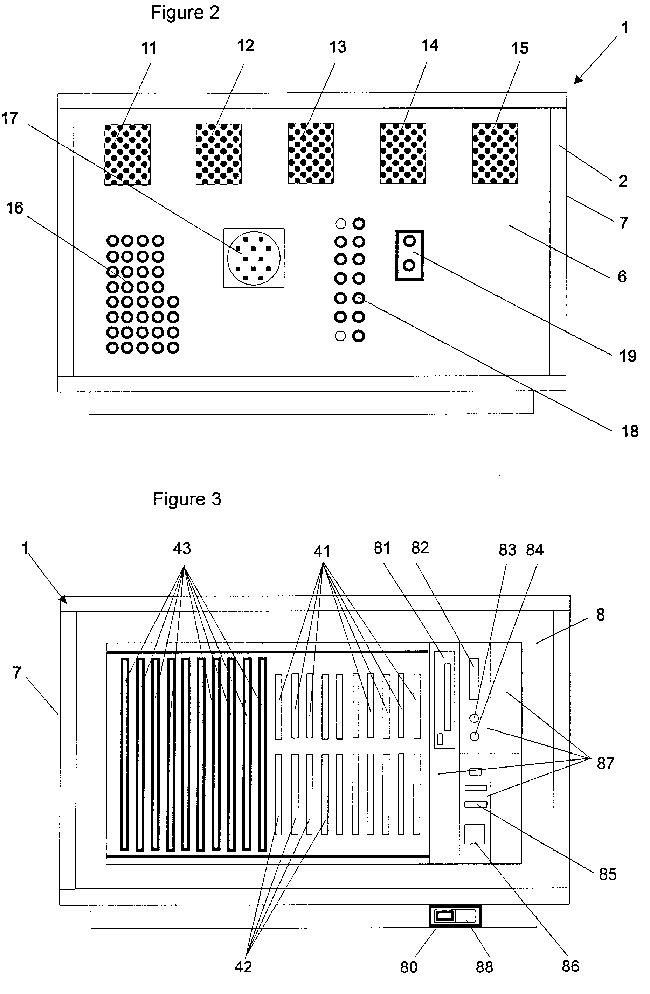

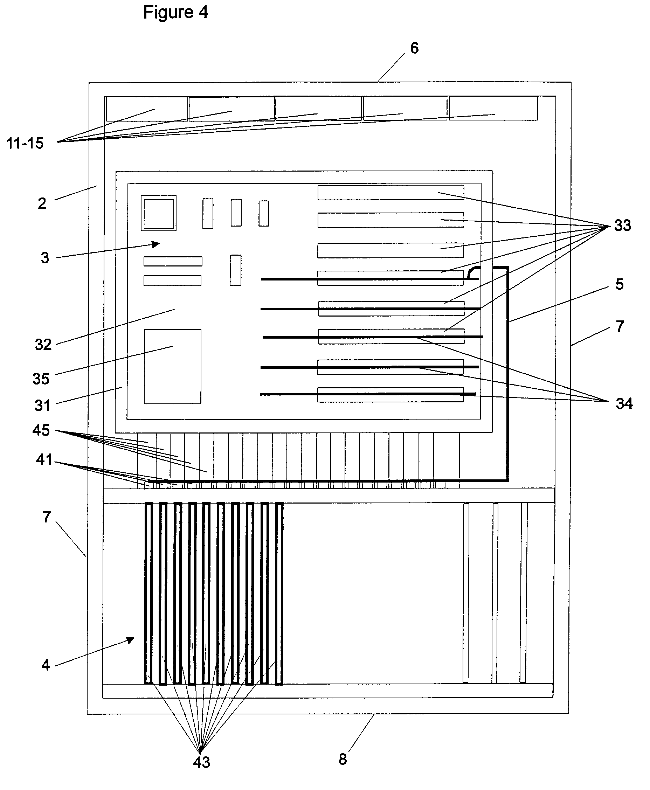

The front panel mounts a variety of input/output (I/O) ports 11 - 17 & 19 (for connection to the ECM), and LEDs 18 (to indicate power supply states). The rear panel 8 has mounted thereon a power ON/OFF switch 80, a floppy disk drive 81 (with a hard disk drive located below it - not shown in Figs 2-4), conventional video output 82 for connection to a monitor 37 (see Fig.1), a keyboard port 83 for connection to a keyboard 36, and mouse 84, serial 85 and network 86 ports of the PC 3, all of which components are mounted on separate sub-panels 87 for ease of replacement/substitution and access. Mains power is supplied through a conventional socket 88.

The PC 3, as mentioned above, is standard and includes the conventional frame 31 and a motherboard 32 with the usual ISA slot connectors 33 which can receive standard ISA interface expansion cards 34. A conventional power supply 35 is included as is a hard disk drive 38 (see Fig.1).

The VME type rack of the input/output section 4 (which can be seen through the open rear of the simulator in Figure 3) is disposed behind the PC 3 and includes two series of connectors 41,42, the first series of connectors 41 being disposed in a row above a corresponding row of second connectors 42, pairs of the first and second connectors 41,42 being aligned so that proprietary I/O interface cards 43 with suitable connectors mounted adjacent one edge can connect with both connectors of a pair at the same time. The first and second connectors 41,42 comprise, in this example, standard multi-pin female VME connectors and the connectors on the I/O interface cards complementary male VME connectors which are capable of withstanding multiple insertions/withdrawals without becoming unreliable in connection.

The ISA bus extension cable 5 is a standard multi-conductor ribbon cable which is connected via an ISA interface card to one of the ISA slot connectors 33 in the PC and to each of the first series of female VME connectors 41, thus extending the ISA bus to the input/output section 4.

The second connectors 42 are individually connected to respective ones of the various I/O ports 11-17 & 19 and LEDs 18 by suitable ribbon cables 45, each extending below the PC 3 from the connectors 41 to the relevant I/O ports 11-19.

The proprietary interface cards 43 each include components specific to the type of input/output processing required, including basic processing components and the required associated logic circuitry. Cards 43 may be of a standard specialised design with the ability to mount specific, specialised daughter boards 43' (as indicated in Fig.1) or, alternatively, cards 43 may be standard and provide appropraite signals to separately mounted cards 43'' (see Fig.1) mounted 'in-line' between the cards 43 and the I/O ports. Additionally, non-standard cards 43 may also be available to provide, eg programmable waveform generator functions, configurable event capturing, fuel injection simulation and the like. The range of I/O cards can be as wide as required for many different applications and does not form any part of the inventive concept of the present simulator.

The PC 3 operates under a standard operating system (OS), eg Windows™ 95 and provides a user interface, on a suitable monitor, through which the user can view the active model, scripts and data logs etc. and manage virtual instrument panels which may contain instruments, controls or calibration tables. Using a standard OS allows data to be transferred to and from spreadsheets, word processing programs, database software and the like. The particular software, the particular types of interface card and the I/O port configurations are not of the essence of the invention and will be provided in the types and numbers required. The network port 86 allows connection of the simulator to a conventional network of PCs.

## Claims

1. A programmable simulator (1) for use in the testing of automobile electronic control modules (ECMs), the simulator comprising
a chassis (2);
an input/output section (4) having a plurality of first (41) and second (42) multi-terminal electrical connectors for coupling to input/output interface cards (43), the second connectors (42) being connected to corresponding input/output ports (11-17,19) supported on the chassis;
an IBM-standard personal computer (PC) (3)mounted on the chassis, the PC having a standard data/address bus therein and a plurality of third multi-terminal electrical connectors (33) for the coupling of standard PC interface cards (34) within the PC; and
a bus extension (5) extending the standard data/address bus to each of the first connectors (41) of the input/output section (4), thereby extending the bus to the input output section,
whereby an input/output interface card (43) engaged with the corresponding first and second connectors (41,42) may be used to provide output signals to or to receive input signals from, corresponding ones of the input/output ports (11-17,19) to enable the simulation of appropriate inputs/outputs to/from an ECM (10) attached to the simulator via the input/output ports, under the control of software running on the PC (3).

2. A programmable simulator (1) according to claim 1, wherein the first (41) and second (42) connectors of the input/output section are arranged in parallel rows whereby an associated input/output card (43) can be connected to the respective first and second connectors adjacent to one edge.

3. A programmable simulator (1) according to claim 1 or claim 2, wherein the connection of the second connectors (42) with the input/output ports (11-17,19) is achieved by the use of individual multi-conductor cables (45).

4. A programmable simulator (1) according to any of claims 1 to 3, wherein the PC standard bus is an ISA, EISA or PCI bus and the bus extension (5) comprises a ribbon cable connected to the bus and to all of the first connectors (41).

5. A programmable simulator (1) according to any of claims 1 to 4, wherein the input/output section (4) comprises a VME type rack.
